# EUROPÄISCHE PATENTSCHRIFT

(11) **EP 2 963 663 B1**
(45) Veröffentlichungstag und Bekanntmachung des Hinweises auf die Patenterteilung: **25.12.2019**
(21) Anmeldenummer: 15171635.4
(22) Anmeldetag: 11.06.2015
(51) Int. Cl.: H01F 41/06, B23K 3/06, B23K 9/12, H02K 15/08, B65H 57/00

(54) **DRAHTFÜHRELEMENT, DRAHTWICKELMASCHINE MIT EINEM SOLCHEN, VERFAHREN ZUM EINBRINGEN VON DRAHT UND VERFAHREN ZUM ZUFÜHREN VON DRAHT**
WIRE GUIDANCE ELEMENT, WIRE ROLLING MACHINE WITH SAME, METHOD FOR INTRODUCING WIRE AND METHOD FOR FEEDING WIRE
ÉLÉMENT DE GUIDAGE DE FIL, MACHINE D'ENROULEMENT DE FIL EN ÉTANT DOTÉE, PROCÉDÉ D'INTRODUCTION DE FIL ET PROCÉDÉ DE GUIDAGE DE FIL

(30) Priorität: 11.06.2014 DE 102014108208
(43) Veröffentlichungstag der Anmeldung: 06.01.2016
(73) Patentinhaber: Friedrich-Alexander-Universität Erlangen-Nürnberg, 91054 Erlangen (DE)
(72) Erfinder: SCHNEIDER, Michael, 90571 Schwaig (DE); RISCH, Florian, 90429 Nürnberg (DE); FRANKE, Jörg, 91080 Marloffstein (DE); BICKEL, Benjamin, 90409 Nürnberg (DE); GÜNTHER, Stefan, 12055 Berlin (DE)
(74) Vertreter: Louis Pöhlau Lohrentz

(56) Entgegenhaltungen:
- DD-A1- 255 187
- DE-A1- 3 837 853
- DE-A1-102011 114 262
- JP-A- H01 222 421
- US-A1- 2009 200 284

## Beschreibung

Die Erfindung betrifft ein Drahtführelement, insbesondere zum Führen eines zu wickelnden Drahtes in einer Drahtwickelmaschine oder zum Zuführen eines Lötdrahtes in einem Lötgerät oder eines Schweißzusatzes in Form eines Drahtes in einer Schweißmaschine. Die Erfindung betrifft auch eine Drahtwickelmaschine mit dem erfindungsgemäßen Drahtführelement. Sie betrifft auch ein Verfahren zum Einbringen von Draht zur Bildung einer Spule an oder in einem oder mehreren Bauteilen einer elektrischen Maschine, wobei der Draht durch ein erfindungsgemäßes Drahtführelement geführt wird. Die Erfindung betrifft ferner ein Verfahren zum Zuführen von Draht von einer Vorratseinrichtung zu einem Arbeitsbereich, wobei der Draht durch ein Drahtführelement geführt wird.

Drahtführelemente weisen üblicherweise einen äußeren Körper auf, in welchem ein Durchlass für den Draht ausgebildet ist. Solche Drahtführelemente werden beispielsweise beim sogenannten Nadelwickelverfahren eingesetzt. Es handelt sich hierbei um ein Hub-Schwenk-Wickelverfahren zum Einbringen von Draht zur Bildung einer Spule an oder in einem oder mehreren Bauteilen einer elektrischen Maschine (an einem Stator, Rotor oder einem Transformator). Um hierbei den zu wickelnden Draht definiert auf dem einen oder mehreren Bauteilen (den sogenannten Wickelkörpern) abzulegen, muss das Drahtführelement bewegt werden, nämlich so geführt werden, dass der aus ihm herausgeführte (insbesondere herausgezogene) Draht die Zwischenräume passieren kann. Hierbei soll der herausgeführte Draht den bereits abgelegten Draht nicht berühren; denn dieser soll nicht beschädigt werden. Ein Hub-Schwenk-Wickelverfahren, insbesondere das Nadelwickelverfahren, wird insbesondere auch zur Herstellung von sogenannten verteilten Wicklungen eingesetzt, bei dem das Drahtführelement durch Nuten eines Statorblechpakets geführt wird. Es wird hierbei nicht ein einzelner Zahn des Statorblechpakets vollständig umwickelt, sondern in einer Folge von mindestens drei Nuten zwischen Zähnen wird die Wicklung von der ersten Nut in die dritte Nut und wieder zurück in die erste Nut geführt, so dass die zweite Nut frei bleibt.

Beim Austreten des zu führenden Drahts aus dem Drahtführelement kann selbiger besonders stark an dessen Drahtauslass abgebogen werden, so dass es zu einer Beschädigung seiner Isolierung kommen kann. Um dem vorzubeugen, wird häufig eine sehr dicke Isolierung vorgesehen, insbesondere z.B. mit dem höchsten Grad gemäß IEC 60317.

Insgesamt werden bei den bekannten Hub-Schwenk- Wickelverfahren nur geringe sogenannte Füllfaktoren erzielt, d.h. es bleiben viele Freiräume dort, wo an sich die Wicklung platziert sein sollte, wobei diese Freiräume später weitgehend mit Harz gefüllt werden.

Zur Erhöhung der Dichte beim Wickeln und Verringerung der Belastung des Drahtes am Drahtauslass, bei welchem der Draht um einen Winkel von z.B. 90° gebogen wird, sieht die DE 10 2011 008 662 A1 folgendes Nadelwickelsystem vor: Ein starres Drahtführelement wird so bewegt, dass seine Drahtaustrittsdrüse stets ins Zentrum eines virtuellen Kreises gerichtet ist und so einen virtuellen Schwerpunkt definiert. Dieses Nadelwickelsystem hat den Nachteil, dass eine aufwendige Mechanik vorgesehen ist, welche sehr viel Platz einnimmt, so dass sie insbesondere zur Wicklung sehr kleiner Wicklungen in kleinen Nuten schlecht geeignet ist. Außerdem ist die Mechanik störanfällig.

Drahtführelemente nach dem Oberbegriff von Anspruch 1 sind aus DE 10 2011 114 262 A1 und US 2009/200284 A1 bekannt.

Es ist die Aufgabe der vorliegenden Erfindung, einen weniger aufwendigen Weg aufzuzeigen, wie Draht an einem Drahtauslass eines Drahtführelements geringer belastet werden kann.

Die Aufgabe wird durch ein Drahtführelement mit den Merkmalen gemäß Patentanspruch 1, durch eine Drahtwickelmaschine mit den Merkmalen gemäß Patentanspruch 10, durch ein Verfahren mit den Merkmalen gemäß Patentanspruch 11 und durch ein Verfahren mit den Merkmalen gemäß Patentanspruch 14 gelöst.

Das erfindungsgemäße Drahtführelement, insbesondere zum Führen eines zu wickelnden Drahtes in einer Drahtwickelmaschine oder zum Zuführen eines Lötdrahtes in einem Lötgerät oder eines Schweißzusatzes in Form eines Drahtes in einer Schweißmaschine, weist somit einen äußeren Körper auf, in welchem ein Durchlass für einen Draht ausgebildet ist, wobei der äußere Körper zumindest abschnittsweise derart formveränderlich ist, dass sich hierbei auch die Form des Durchlasses ändert. Das Drahtführelement weist einen äußere Körper mit einer Vielzahl von Stellelementen auf, welche unter der Wirkung einer elektrischen Spannung, eines elektrischen Stromes oder eines Magnetfeldes als physikalischer Stellgröße ihre Form verändern, insbesondere ihr Volumen ändern. Der Körper weist Mittel auf, die einzelnen Stellelemente selektiv mit der physikalischen Stellgröße elektrischer Spannung, elektrischem Strom oder Magnetfeld zu beaufschlagen. Solche Stellelemente wie z.B. Piezoelemente oder dielektrische Aktoren sind präzise ansteuerbar, um eine Formveränderung des äußeren Körpers definiert einzustellen.

Eine Vielzahl von Stellelementen sind als zwei oder mehr Stellelemente zu verstehen.

Auf diese Weise kann dafür gesorgt werden, dass sich das Drahtführelement bei starker Belastung des Drahtes am Auslass des Drahtführelements derart in seiner Form verändert, dass sich diese Belastung verringert.

Insbesondere beim Einsatz in einer Drahtwickelmaschine können hohe Werte für einen Füllfaktor erzielt werden, d.h. der zu wickelnde Draht kann sehr dicht gewickelt werden. Der Draht kann hierbei auch eine dünnere Isolierung als bei bisherigen gleichartigen Wicklungen aufweisen.

Es gibt mehrere Ausführungsformen von aktiven Drahtführelementen. Als aktiv ist ein solches Drahtführelement anzusehen, bei dem eine Änderung einer äußeren Bedingung (physikalische Größe wie z.B. Temperatur) oder eines Steuerparameters (Beaufschlagung mit einer elektrischen oder magnetischen Größe) die Formveränderung des äußeren Körpers bewirkt.

Es kann vorgesehen sein, dass das Drahtführelement passiv ausgeführt ist, d.h. (unmittelbar) unter der Wirkung einer durch einen Draht in den Durchlass auf ihn ausgeübten Kraft seine Form verändern. Eine passive Ausführungsform hat den Vorteil, dass keine aufwendige Steuerung notwendig ist und daher komplexe und fehleranfällige Bauelemente entfallen.

Es kann vorgesehen sein, dass am Drahtführelement eine Vielzahl von Stellelementen längs der Längserstreckung des äußeren Körpers angeordnet. Bevorzugt sind ferner zumindest zwei und besonders bevorzugt zumindest drei Stellelemente in unterschiedlichen Sektoren eines Ringes um den Durchlass angeordnet.

Es kann vorgesehen sein, dass bei dem Drahtführelement der äußere Körper eine Mehrzahl von starren Hülsen aufweist, welche paarweise durch jeweils zumindest ein flexibles Verbindungsstück miteinander gekoppelt sind. Während die starren Hülsen für eine Grundstabilität sorgen, erlauben die flexiblen Verbindungsstücke die Formveränderung.

Es kann vorgesehen sein, dass der äußere Körper einen flexiblen Schlauch und erste Metallhülsen aufweisen, welche auf dem Schlauch aufsitzen und voneinander beabstandet sind. Statt Metallhülsen können auch andere starre Hülsen, etwa aus Hartplastik, vorgesehen sein. Der flexible Schlauch selbst sorgt somit für die mögliche Formveränderung, allerdings lediglich dort, wo nicht die ersten Metallhülsen auf ihm aufsitzen, sondern in dem Zwischenbereich zwischen zwei benachbarten ersten Metallhülsen. Die ersten Metallhülsen sorgen für die notwendige Stabilität, die der flexible Schlauch als solche alleine nicht in dem gewünschten Maße bietet.

Es kann vorgesehen sein, dass zu den ersten Metallhülsen, welche dann ringförmig ausgebildet sind und einen ersten Innendurchmesser aufweisen, dass ringförmige zweite Metallhülsen auf einem Abschnitt je zweier zueinander benachbarter erster Metallhülsen aufsitzen, wobei diese ringförmigen zweiten Metallhülsen einen zweiten Innendurchmesser aufweisen, welcher größer als der erste Innendurchmesser ist. Sie umgeben somit den flexiblen Schlauch dort, wo keine erste Metallhülse vorhanden ist und schützen diesen flexiblen Schlauch somit, ohne aber dessen Flexibilität wesentlich einzuschränken.

Es kann vorgesehen sein, dass bei dem Drahtführelementes der äußere Körper rohrförmig ausgebildet ist und zumindest einen Teil aus einem Material umfasst, welches bei einer Temperaturänderung eine Formänderung dieses zumindest einen Teils bewirkt.

Ein solches Material ist insbesondere ein Formgedächtnismaterial, typischerweise eine Formgedächtnislegierung (z.B. Nitinol). Der äußere Körper umfasst insbesondere ein Rohr aus einem solchen Formgedächtnismaterial, und an selbigem sind elektrische Anschlüsse zum Bestromen des Formgedächtnismaterials bereitgestellt, wobei durch das Beschicken des Formgedächtnismaterials selbst mit dem elektrischen Strom sich dieses erwärmt, und somit die gewünschte Temperaturänderung zur Formänderung des äußeren Körpers bewirkt wird.

Alternativ kann aus einer Formgedächtnislegierung (oder alternativ einem Bimetall) eine Mehrzahl von Flachdrähten ausgebildet sein. Auf diesen Flachdrähten soll jeweils eine Mehrzahl von Heizspulen angeordnet sein. Die Flachdrähte sollen zusammen mit den Heizspulen in ein elastisches, elektrisch isolierendes Material eingebettet sein, welches insbesondere thermisch leitfähig ist. Durch Beaufschlagung der Heizspulen mit einem Heizstrom erwärmen sich diese und damit die Flachdrähte, wobei bei einer Formgedächtnislegierung oder einem Bimetall der Flachdraht sodann seine Form ändert und somit auch die Form des äußeren Körpers ändert.

In einer nicht von den Ansprüchen 1-14 abgedeckten Ausgestaltung eines Drahtführungselements kann vorgesehen sein, dass der äußere Körper mit einem oder mehreren Einzelelementen, in welchem zumindest ein Seilzug zur Formveränderung des Drahtführelementes geführt ist. Das Drahtführelement weist zu jedem Seilzug eine Winde oder Zugeinrichtung außerhalb des äußeren Körpers mit einem zugehörigen elektrischen Antrieb auf, mittels dessen der jeweilige Seilzug, insbesondere selektiv, zur Formveränderung einsetzbar ist. Bei dieser (elektro-) mechanischen Ausführungsform des Drahtführelementes besteht eine geringere Fehleranfälligkeit gegenüber Störungen in elektrischen Einrichtungen. Das Einzelelement und die mehreren Einzelelemente können vorzugsweise in Verbindung mit, d.h. zusätzlich zu den Stellelementen ausgebildet sein.

Bei allen Drahtführelementen ist bevorzugt eine Sensoreinrichtung zur Ermittlung der von dem Draht auf das Drahtführelement ausgeübten Kraft angeordnet, insbesondere im Bereich eines Drahtauslasses. Mittels dieser Sensoreinrichtung, die insbesondere eine piezokeramische Sensorschicht aufweisen kann, können solche Messwerte ermittelt werden, die im Rahmen einer Steuerung oder Regelung eingesetzt werden, bei der entweder die Formveränderung durch die Stellgröße bewirkt wird (bei aktiven Drahtelementen), oder bei der eine zusätzliche Drahtbremse außerhalb des Drahtführelements die Drahtzugkraft einstellt.

Zur Erfindung gehört auch eine Drahtwickelmaschine mit dem erfindungsgemäßen Drahtführelement.

Bei dem erfindungsgemäßen Verfahren zum Einbringen von Draht zur Bildung einer Spule an oder in einem oder mehreren Bauteilen einer elektrischen Maschine wird der Draht durch ein Drahtführelement der erfindungsgemäßen Art geführt. Das Drahtführelement ändert entweder unter der Wirkung einer von dem Draht ausgeübten Kraft (bei passivem Drahtführelement) oder aufgrund einer aktiven Ansteuerung einer mechanischen oder elektrischen Stellgröße (bei aktivem Drahtführelement) die Form seines äußeren Körpers, insbesondere auch wiederholt. Das Drahtführelement weist einen äußere Körper mit einer Vielzahl von Stellelementen auf, welche unter der Wirkung einer elektrischen Spannung, eines elektrischen Stromes oder eines Magnetfeldes als physikalischer Stellgröße ihre Form verändern, insbesondere ihr Volumen ändern. Der Körper weist Mittel auf, die einzelnen Stellelemente selektiv mit der physikalischen Stellgröße elektrischer Spannung, elektrischem Strom oder Magnetfeld zu beaufschlagen. Solche Stellelemente wie z.B. Piezoelemente oder dielektrische Aktoren sind präzise ansteuerbar, um eine Formveränderung des äußeren Körpers definiert einzustellen.

Dieses Verfahren ist vor allem auch dann vorteilhaft einsetzbar, wenn es ohne die Formänderung des äußeren Körpers zu einer Belastung des Drahts und insbesondere seiner Isolierung kommen könnte.

Dieser Vorteil ist insbesondere dann gegeben, wenn die Spule als verteilte Wicklung bereitgestellt werden soll, aber auch z.B. beim Wickeln von Einzelzahnspulen oder konzentrierten Wicklungen.

Im Falle der vorgesehenen Sensoreinrichtung gibt selbige Messsignale ab, und in Antwort auf diese erfolgt die Ansteuerung der mechanischen oder elektrischen Stellgröße.

Das erfindungsgemäße Verfahren zum Zuführen von Draht von einer Vorratseinrichtung zu einem Arbeitsbereich beinhaltet, dass der Draht durch ein Drahtführelement geführt wird, wobei die von dem Draht auf das Drahtführelement ausgeübte Drahtzugkraft gemessen wird und in Abhängigkeit von dieser die Form von zumindest einem Teil des Drahtführelements derart geändert wird, dass die Drahtzugkraft verringert und/oder auf einen vorbestimmten Wert geregelt wird.

Die Drahtzugkraft kann insbesondere im Hinblick auf ihren Betrag und ihre Richtung, vorzugsweise in mehrere Richtungen, gemessen werden, und ein oder mehrere Sollwerte bei einer Regelung kann bzw. können sich auf den Betrag und/oder die Richtung beziehen.

Nachfolgend werden bevorzugte Ausführungsformen der Erfindung unter Bezug auf die Zeichnung näher beschrieben, in der:
- Fig. 1: schematisch eine Drahtwickelmaschine mit einem Drahtführelement gemäß einer ersten Ausführungsform beim Vorsehen einer verteilten Wicklung veranschaulicht,
- Fig. 2: das Drahtführelement gemäß der ersten Ausführungsform aus Fig. 1 in vergrößerter Ansicht im Schnitt veranschaulicht,
- Fig. 3: eine zweite Ausführungsform des Drahtführelements im Schnitt veranschaulicht,
- Fig. 4: eine Abwandlung der zweiten Ausführungsform des Drahtführelements im Schnitt veranschaulicht,
- Fig. 5: eine dritte Ausführungsform des Drahtführelements im Schnitt in einem Grundzustand veranschaulicht,
- Fig. 6: das Drahtführelement aus Fig. 5 in einem verformten Zustand veranschaulicht,
- Fig. 7: eine vierte Ausführungsform des Drahtführelements im Schnitt veranschaulicht und
- Fig. 8: schematisch die Besetzung eines bei dem Drahtführelement aus Fig. 7 verwendeten Flachdrahtes mit Heizspulen veranschaulicht,
- Fig. 9: eine fünfte Ausführungsform des erfindungsgemäßen Drahtführelementes im Schnitt veranschaulicht,
- Fig. 10: den Ausschnitt X aus Fig. 9 in vergrößerter Darstellung zeigt,
- Fig. 11: den Schnitt XI-XI aus Fig. 10 zeigt,
- Fig. 12: eine Ausführungsform eines nicht von den Ansprüchen 1-14 abgedeckten Drahtführelementes im Schnitt veranschaulicht und
- Fig. 13: die Einbindung des Drahtführelements aus Fig. 12 in einen Regelkreis veranschaulicht.

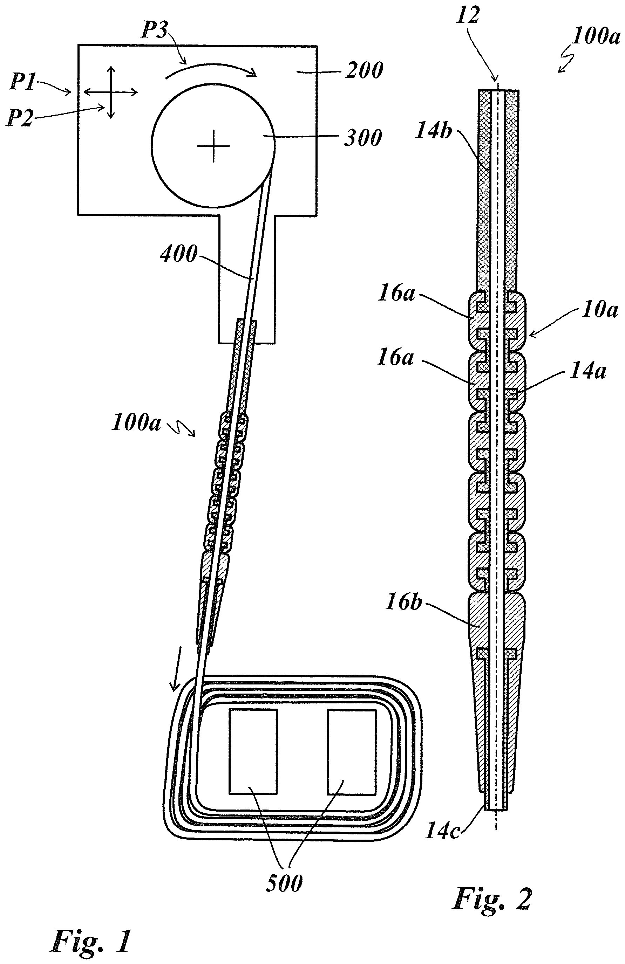

Ein Drahtführelement 100a (Fig. 1, Fig. 2) ist auf eine in der Zeichnung nicht gezeigte Weise an einem Gestell 200 angeordnet, welches Teil einer Drahtwickelmaschine ist. An dem Gestell 200 ist drehbar eine Winde 300 gelagert, auf der ein Draht 400 aufgewickelt ist. Der Draht 400 ist durch einen in einem äußeren Körper 10a des Drahtführelements 100a vorgesehenen Durchlass 12 geführt. In der Fig. 1 ist dargestellt, wie der Draht zur Bildung einer verteilten Wicklung um hier nur symbolisch gezeigte Zähne 500 beispielsweise eines Stators einer elektrischen Maschine gewickelt wird. Kennzeichen einer verteilten Wicklung ist, dass nicht ein einzelner Zahn 500 umwickelt wird, sondern der Draht eine Nut zwischen zwei Zähnen 500 auslässt.

Damit der Draht an die jeweils richtige Stelle geführt ist, wird das Gestell 200 hin- und herbewegt, wobei die Pfeile P1 und P2 in Fig. 1 die Bewegungsmöglichkeiten anzeigen. Nicht immer tritt der Draht 400 wie in Fig. 1 gezeigt gerade aus dem Drahtführelement 100a aus. Um zu vermeiden, dass sich der Draht in zu starkem Maße biegt, ist vorliegend das Drahtführelement formveränderlich ausgebildet, so dass es bei Beaufschlagung mit einer bestimmten Drahtzugkraft selbst gebogen wird und so eine Biegung des Drahtes verringert.

Wie in Fig. 2 zu sehen, weist der äußere Körper 10a des Drahtführelements 100a eine Mehrzahl von starren Hülsen 14a auf, die im Wesentlichen die Form eines Rohrs mit zwei Ringen an beiden Rohrenden haben. Eine weitere Hülse 14b ist auf der Seite des Gestells 200 vorgesehen und umfasst einen etwas längeren Schaft, und eine Auslasshülse 14c dient dazu, den Draht sicher im Bereich des Drahtauslasses aus dem Drahtführelement 10a zu führen. Die Hülsen 14a sind mittels flexibler Verbindungsstücke 16a miteinander verbunden bzw. gekoppelt. Die Hülse 14b ist über ein solches flexibles Verbindungsstück 16a mit der nächsten starren Hülse 14a gekoppelt und im Bereich der Auslasshülse 14c ist ein flexibles weiteres Stück 16b mit geeigneter Passform vorgesehen. Die Anordnung, wie sie in Fig. 2 gezeigt ist, ahmt die Wirbelsäule eines Wirbeltieres nach, wobei die Hülsen 14a den Wirbeln und die flexiblen Verbindungsstücke 16a den Bandscheiben entsprechen. Wie bei einer Wirbelsäule tragen die starren Hülsen 14a zur Grundstabilität bei, die flexiblen Verbindungsstücke 16a ermöglichen aber eine Relativbewegung der starren Hülsen 14a zueinander, so dass der äußere Körper 10a in sich biegbar ist. Die erfindungsgemäßen Stellelemente können in diesen Ausführungsbeispiel als flexible Verbindungsstücke 16a und/oder als Hülsen 14a ausgebildet sein. Diese Stellelemente können zum Beispiel als Piezoelement, dielektrische Aktoren, Bimetall oder Formgedächtnismaterial ausgebildet sein.

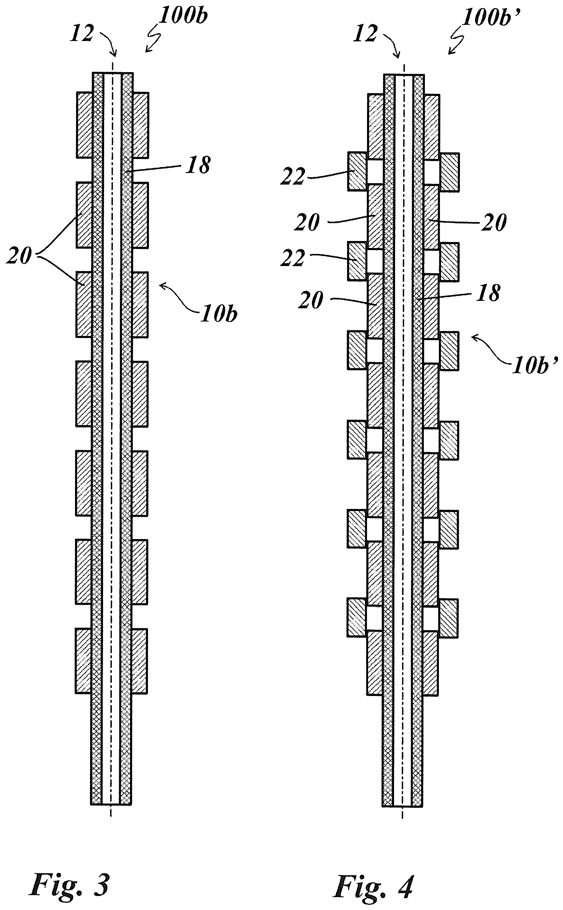

Bei einer zweiten Ausführungsform eines Drahtelements 100b, wie es in Fig. 3 gezeigt ist, ist in einem flexiblen Schlauch 18 der Durchlass 12 für den Draht 400 ausgebildet, und der äußere Körper 10b ist durch den flexiblen Schlauch 18 und darauf aufsitzende äußere Metallhülsen 20 gebildet, welche insbesondere ringförmig sind und soweit zueinander beabstandet sind, dass sie einerseits den flexiblen Schlauch 18 stabilisieren, andererseits aber ein Sich-Biegen des äußeren Körpers 10b zumindest an den Stellen zwischen den ersten Metallhülsen erlauben. Die erfindungsgemäßen Stellelemente können in diesen Ausführungsbeispiel als flexibler Schlauch 18 und/oder als Metallhülsen 20 ausgebildet sein. Diese Stellelemente können zum Beispiel als Piezoelement, dielektrische Aktoren, Bimetall oder Formgedächtnismaterial ausgebildet sein wobei die Stellelemente auch in dem flexiblen Schlauch 18 angeordnet sein können.

In einer in Fig. 4 gezeigten Abwandlung dieser zweiten Ausführungsform des Drahtführelements 100b' umfasst der äußere Körper 10b' zusätzlich zu dem flexiblen Schlauch 18 und den ersten Metallhülsen 20 zweite Metallhülsen 22, deren Innendurchmesser mehr oder weniger dem Außendurchmesser der ersten Metallhülsen 20 entspricht, und die genau dort aufsitzen, wo Zwischenräume zwischen den ersten Teilhülsen 20 vorgesehen sind. Diese Anordnung ist besonders stabil, bewahrt aber dennoch nahezu dieselbe Flexibilität des äußeren Körpers 10b', wie sie der äußere Körper 10b hat. Die erfindungsgemäßen Stellelemente können in diesen Ausführungsbeispiel als erste Metallhülsen 20 und/oder als zweite Metallhülsen 22 ausgebildet sein. Diese Stellelemente können zum Beispiel als Piezoelement, dielektrische Aktoren, Bimetall oder Formgedächtnismaterial ausgebildet sein.

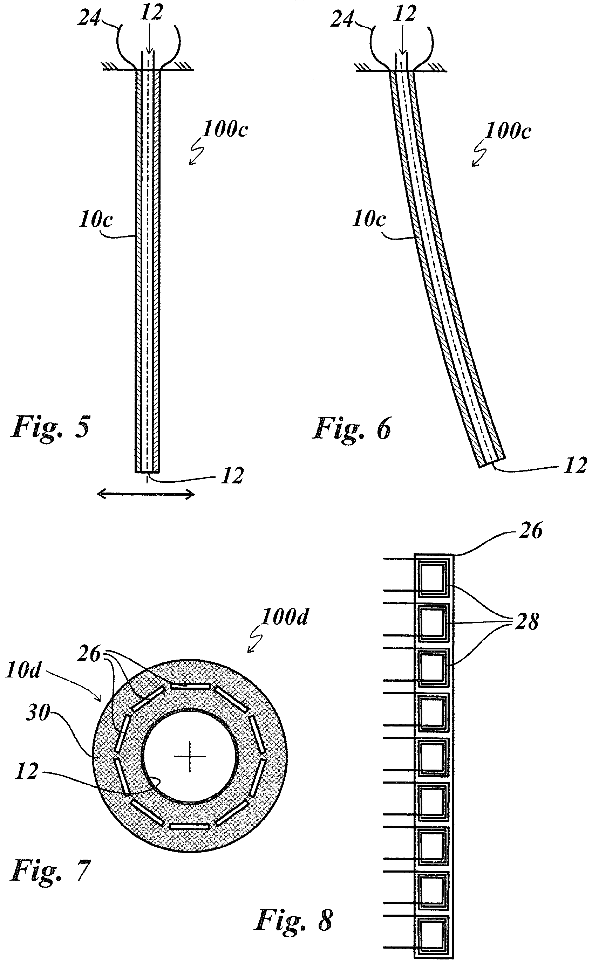

Bei einer dritten Ausführungsform eines Drahtführelements 100c gemäß Fig. 5 und 6 umfasst der äußere Körper 10c ein Rohr aus einem Material mit Formgedächtnis, insbesondere einer Formgedächtnislegierung wie z.B. Nitinol. Kennzeichen einer Formgedächtnislegierung ist es, dass diese bei einer bestimmten Temperatur, z.B. nach einem Erwärmen des Materials, eine zuvor eingeprägte Form einnimmt. Die Formänderung ist anhand eines Vergleichs der Figuren 5 und 6 ersichtlich. Über elektrische Anschlüsse 24, mittels derer der äußere Körper 10c unmittelbar bestrombar ist, lässt sich ein Strom durch den äußeren Körper 10c leiten, der zur Erwärmung desselben und damit Einnahme der eingeprägten Form gemäß Fig. 6 führt. Der Körper 10c kann als eine Vielzahl von Stellelementen ausgebildet sein.

Bei einer vierten Ausführungsform des Drahtführelements 100d gemäß Fig. 7 und 8 umfasst der äußere Körper 10d eine Mehrzahl von Stellelemente oder Flachdrähten 26 die als Stellelemente ausgebildet sind, welche in ein flexibles Material 30 wie beispielsweise Gummi eingebettet sind. Die Fig. 7 zeigt zehn solcher Flachdrähte, denkbar sind aber auch Anordnungen mit mehr (elf, zwölf, vierzehn, fünfzehn, achtzehn, zwanzig, etc.) oder weniger (acht, sechs, drei oder zwei) Flachdrähten denkbar.

Wie in Fig. 8 zu sehen, ist jedes Stellelement bzw. jeder Flachdraht 26 ausgebildet als Stellelement, der beispielsweise aus einer Formgedächtnislegierung wie etwa Nitinol besteht, mit einer Mehrzahl von Heizspulen 28 versehen, die einzeln angesteuert werden können und so eine lokal verschiedene Erwärmung der Flachdrähte 26 bewirken können und insgesamt eine Formänderung des äußeren Körpers 10d des Drahtführelements 100d bewirken.

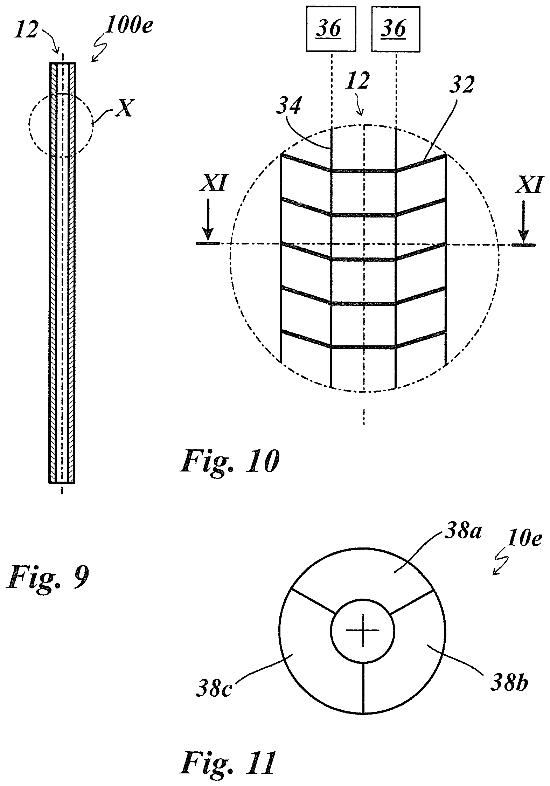

Bei einer fünften Ausführungsform des Drahtführelements 100e, wie sie anhand der Figuren 9 bis 11 veranschaulicht ist, umfasst der äußere Körper 10e eine Mehrzahl von Stellelementen 32, welche unter Beaufschlagung mit einer Steuergröße wie beispielsweise einer elektrischen Spannung oder eines Magnetfeldes ihr Volumen ändern. In einer Ausführungsform sind diese Stellelemente 32 piezoelektrische Elemente. In einer anderen Ausführungsform sind sie als dielektrische Aktoren ausgebildet. Über in Fig. 10 symbolisch gezeigte Zuführleitungen 34 können die einzelnen Stellelemente 32 selektiv unter Steuerung durch Mittel 36 zum Steuern mit der Steuergröße beaufschlagbar sein. Im Beispielsfalle eines Piezoelements als Stellelement 32 wird eine entsprechende Steuerspannung zur Bewirkung einer Volumenänderung des jeweiligen Piezoelements 32 bereitgestellt.

Damit der äußere Körper 10e des Drahtführelements 100e nicht nur seine Länge verändert, sondern sich auch biegt, sind in einzelnen Sektoren 38a, 38b, 38c jeweils unterschiedliche Stellelemente 32 bzw. Teile von solchen vorgesehen, die selektiv angesteuert werden können. Wird beispielsweise die Folge von Stellelementen 32 im Sektor 38a angesteuert, kann sich das Volumen der Stellelemente 32 vergrößern und ein Sich-Biegen des äußeren Körpers 10e zu den Sektoren 38b, 38c hin bewirken.

Die in Fig. 11 gezeigte Zahl von drei Sektoren ist lediglich beispielhaft, es können auch zwei oder mehr als drei Sektoren vorgesehen sein.

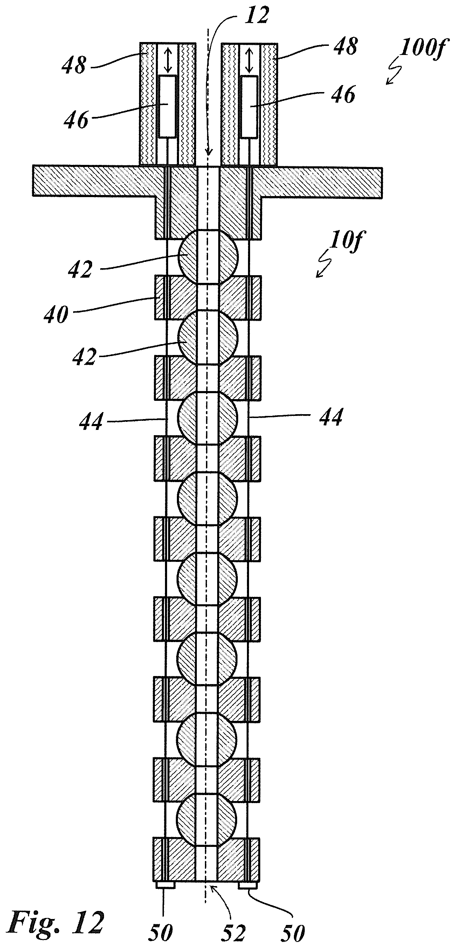

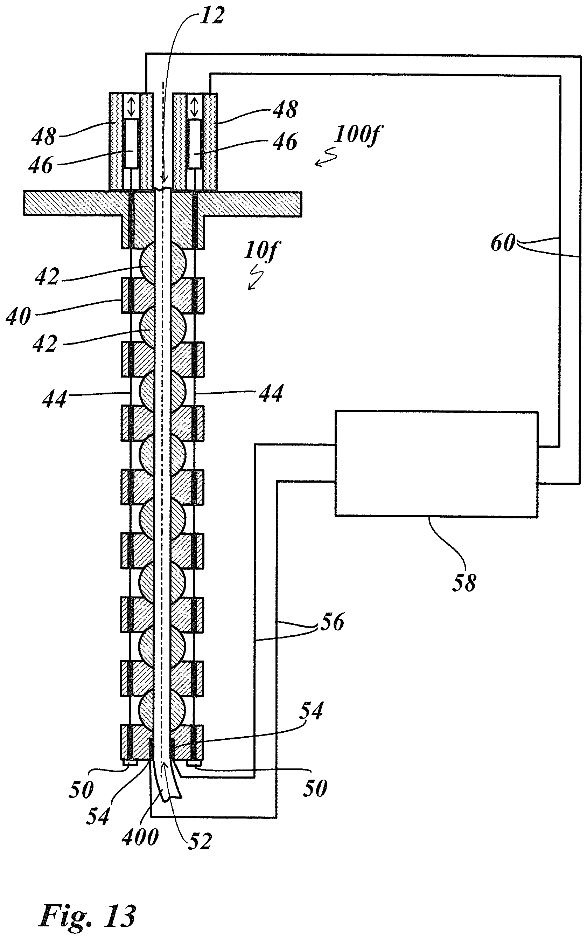

Bei einer anhand der Figuren 12 und 13 veranschaulichten Ausführungsform eines nicht von den Ansprüchen 1-14 abgedeckten Drahtführelements 100f umfasst der äußere Körper 10f eine Mehrzahl von Einzelelementen 40, welche beweglich auf Stützelementen 42 angeordnet sind. Durch die Einzelelemente 40 sind Seilzüge 44 geführt, welche auf Winden 46 aufgewickelt sind. Die Winden 46 sind unter Ansteuerung einer elektrischen Maschine 48 antreibbar, um die Seilzüge 44 anzuziehen. Wird in dem äußeren Körper 10f einer der Seilzüge 44 angezogen und der andere nicht, kommt es zu einem Sich-Biegen des äußeren Körpers 10f. Die Seilzüge sind an Endstücken 50 befestigt. Im Bereich des Drahtauslasses 52 kann eine in Fig. 13 gezeigte Sensoreinrichtung 54 vorgesehen sein (so wie es in Fig. 13 gezeigt ist). Die Sensoreinrichtung 54 ist beispielsweise als piezokeramische Sensorschicht bereitgestellt, welche das Ausmaß der von dem Draht 400 auf die piezokeramische Sensorschicht ausgeübten Kraft ermittelt. Ist die piezokeramische Sensorschicht 54 in mehrere Ringsektoren unterteilt, lässt sich auch die Richtung der von dem Draht 400 ausgeübten Drahtzugkraft ermitteln. Beispielsweise sind zwei solche Sektoren jeweils über Leitungen 56 mit einer Regeleinrichtung 58 verbunden, die über Steuerleitungen 60 die elektrischen Maschinen 48 ansteuert, welche die Winden 46 bewegen. Die Regeleinrichtung regelt die Drahtzugkraft und ggf. deren Richtung auf einen vorbestimmten Wert. Die erfindungsgemäßen Stellelemente können in diesen Ausführungsbeispiel als Stützelemente 42 und/oder als Einzelelemente 40 ausgebildet sein. Diese Stellelemente können zum Beispiel als Piezoelement, dielektrische Aktoren, Bimetall oder Formgedächtnismaterial ausgebildet sein.

## Patentansprüche

1. Drahtführelement (100a, 100b, 100b', 100c, 100d, 100e, 100f), zum Führen eines zu wickelnden Drahtes (400) in einer Drahtwickelmaschine (200, 300) oder zum Zuführen eines Lötdrahtes in einem Lötgerät oder eines Schweißzusatzes in Form eines Drahtes in einer Schweißmaschine, mit einem äußeren Körper (10a, 10b, 10b', 10c, 10d, 10e, 10f) in dem ein Durchlass (12) für einen Draht ausgebildet ist, wobei der äußere Körper (10a, 10b, 10b', 10c, 10d, 10e, 10f) zumindest abschnittsweise derart formveränderlich ist, dass sich hierbei auch die Form des Durchlasses (12) ändert.
**dadurch gekennzeichnet,**
**dass** der äußere Körper eine Vielzahl von Stellelementen (32) aufweist, die unter der Wirkung einer elektrischen Spannung, eines elektrischen Stromes oder eines Magnetfeldes als physikalischer Stellgröße ihre Form verändern, insbesondere ihr Volumen ändern, und wobei der äußere Körper Mittel (34, 36) aufweist, die einzelnen Stellelemente (32) selektiv mit der physikalischen Stellgröße elektrischer Spannung, elektrischem Strom oder Magnetfeld zu beaufschlagen.

2. Drahtführelement nach Anspruch 1,
**dadurch gekennzeichnet,**
**dass** eine Vielzahl von Stellelementen (32) längs der Längserstreckung des äußeren Körpers (10e) angeordnet sind.

3. Drahtführelement nach einem der vorangehenden Ansprüche,
**dadurch gekennzeichnet,**
**dass** bei dem Drahtführelement zumindest zwei und bevorzugt zumindest drei Stellelemente (32) in unterschiedlichen Sektoren (38a, 38b, 38c) eines Rings um den Durchlass (12) angeordnet sind.

4. Drahtführelement nach einem der vorangehenden Ansprüche,
**dadurch gekennzeichnet,**
**dass** bei dem Drahtführelement der äußere Körper (10a) eine Mehrzahl von starren Hülsen (14a, 14b) aufweist, die paarweise durch jeweils zumindest ein flexibles Verbindungsstück (16a) miteinander gekoppelt sind, vorzugsweise, dass bei dem Drahtführelement der äußere Körper (10b, 10b') einen flexiblen Schlauch (18) und erste Metallhülsen (20) aufweist, die auf dem Schlauch (18) aufsitzen und voneinander beabstandet sind.

5. Drahtführelement nach einem der vorangehenden Ansprüche,
**dadurch gekennzeichnet,**
**dass** bei dem äußeren Körper (10b') des Drahtführelements ringförmige erste Metallhülsen (20) mit einem erstem Innendurchmesser einen flexiblen Schlauch (18) unmittelbar umgeben und ringförmige zweite Metallhülsen (22) mit einem zweitem Innendurchmesser, der größer als der erste Innendruchmesser ist, auf einem Abschnitt je zweier zueinander benachbarter erster Metallhülsen (20) aufsitzen und so den flexiblen Schlauch (18) dort umgeben, wo keine erste Metallhülse (20) vorhanden ist.

6. Drahtführelement nach einem der vorangehenden Ansprüche,
**dadurch gekennzeichnet,**
**dass** bei dem Drahtführelement der äußere Körper (10c) rohrförmig ausgebildet ist und zumindest einen Teil aus einem Material umfasst, das bei einer Temperaturänderung eine Formänderung dieses zumindest einen Teils bewirkt, vorzugsweise,dass das Drahtführelement ein Rohr (10c) aus einem Formgedächtnismaterial aufweist, insbesondere einer Formgedächtnislegierung aufweist, wobei an dem Rohr (10c) elektrische Anschlüsse (24) zum Bestromen des Formgedächtnismaterials bereitgestellt sind.

7. Drahtführelement nach Anspruch 6,
**dadurch gekennzeichnet,**
**dass** das Drahtführelement eine Mehrzahl von Flachdrähten (26) aus einer Formgedächtnislegierung oder einem Bimetall aufweist, auf dem jeweils eine Mehrzahl von Heizspulen (28) angeordnet sind und die zusammen mit diesen Heizspulen (28) in ein elastisches, elektrisch isolierendes Material (30) eingebettet sind, welches insbesondere thermisch leitfähig ist.

8. Drahtführelement nach einem der vorangehenden Ansprüche,
**dadurch gekennzeichnet,**
**dass** das Drahtführelement im Bereich eines Drahtauslasses (52) eine Sensoreinrichtung (54) aufweist zur Ermittlung der von dem Draht auf das Drahtführelement (100c, 100d, 100e, 100f) ausgeübten Kraft .

9. Drahtführelement nach Anspruch 8,
**dadurch gekennzeichnet,**
**dass** bei dem Drahtführelement die Sensoreinrichtung (54) eine piezokeramische Sensorschicht aufweist.

10. Drahtwickelmaschine (200, 300) mit einem Drahtführelement (100a, 100b, 100b', 100c, 100d, 100e, 100f) nach einem der Ansprüche 1 bis 9.

11. Verfahren zum Einbringen von Draht zur Bildung einer Spule an oder in einem oder mehreren Bauteilen einer elektrischen Maschine, wobei der Draht (400) durch ein Drahtführelement (100a, 100b, 100b', 100c, 100d, 100e, 100f) nach einem der Ansprüche 1 bis 9 geführt wird und das Drahtführelement (100a, 100b, 100b', 100c, 100d, 100e, 100f) entweder unter der Wirkung einer von dem Draht (400) ausgeübten Kraft oder aufgrund einer aktiven Ansteuerung einer mechanischen oder elektrischen Stellgröße die Form seines äußeren Körpers (10a, 10b, 10b', 10c, 10d, 10e, 10f) ändert, insbesondere wiederholt ändert.

12. Verfahren nach Anspruch 11, wobei bei dem Verfahren die Spule als verteilte Wicklung bereitgestellt wird.

13. Verfahren nach Anspruch 11 oder 12, wobei bei dem Verfahren ein Drahtführelement (100c, 100d, 100e, 100f) nach Anspruch 9 oder 10 eingesetzt wird, und wobei die Ansteuerung in Reaktion auf von der Sensoreinrichtung (54) abgegebene Messsignale erfolgt.

14. Verfahren zum Zuführen von Draht von einer Vorratseinrichtung zu einem Arbeitsbereich, wobei bei dem Verfahren der Draht durch ein Drahtführelement (100c, 100d, 100e, 100f) nach einem der Ansprüche 1 bis geführt wird, wobei die von dem Draht auf das Drahtführelement (100c, 100d, 100e, 100f) ausgeübte Drahtzugkraft gemessen wird und in Abhängigkeit von dieser die Form von zumindest einem Teil des Drahtführelements (100c, 100d, 100e, 100f) derart geändert wird, dass die Drahtzugkraft verringert und/oder auf einen vorbestimmten Wert geregelt wird. wobei die Drahtzugkraft im Hinblick auf ihren Betrag und ihre Richtung gemessen wird.

## Claims

1. Wire guiding element (100a, 100b, 100b', 100c, 100d, 100e, 100f), for guiding a wire (400) to be wound in a wire winding machine (200, 300), or for feeding a solder wire in a soldering machine or a welding filler in the form of a wire in a welding machine, having an outer body (10a, 10b, 10b', 10c, 10d, 10e, 10f), in which a passage (12) is formed for a wire, wherein the outer body (10a, 10b, 10b', 10c, 10d, 10e, 10f) is at least in sections variable in its shape, such that the shape of the passage (12) also changes herein,
**characterised in that**,
the outer body has a plurality of adjustment elements (32), which, under the effect of an electrical voltage, an electrical current or a magnetic field as a physical regulating variable, change their shape, in particular, change their volumes, and wherein the outer body has means (34, 36) to selectively load the individual adjustment elements (32) with the physical regulating variable electrical voltage, electrical current or magnetic field.

2. Wire guiding element according to claim 1,
**characterised in that**,
a plurality of adjustment elements (32) are arranged along the longitudinal extension of the outer body (10e).

3. Wire guiding element according to one of the preceding claims,
**characterised in that**,
in the wire guiding element, at least two and preferably at least three adjustment elements (32) are arranged in different sectors (38a, 38b, 38c) of a ring around the passage (12).

4. Wire guiding element according to one of the preceding claims,
**characterised in that**,
in the wire guiding element, the outer body (10a) has a plurality of rigid sleeves (14a, 14b) which are coupled with each other in pairs by at least one flexible connecting piece (16a), respectively, preferably **in that**, in the wire guiding element, the outer body (10b, 10b') has a flexible tube (18) and first metal sleeves (20) which rest on the tube (18) and are spaced apart from one another.

5. Wire guiding element according to one of the preceding claims,
**characterised in that**,
in the outer body (10b') of the wire guiding element, ring-shaped first metal sleeves (20) having a first inner diameter immediately surround a flexible tube (18) and ring-shaped second metal sleeves (22) having a second inner diameter which is larger than the first inner diameter, rest on a section of each two mutually adjacent first metal sleeves (20), thus surrounding the flexible tube (18) in places where no first metal sleeve (20) is available.

6. Wire guiding element according to one of the preceding claims,
**characterised in that**,
in said wire guiding element, the outer body (10c) is configured in a tubular manner and comprises at least one part made of a material that, upon altering the temperature, effectuates a change in shape of this at least one part, preferably **in that** the wire guiding element has a tube (10c) made of a shape memory material, in particular a shape memory alloy, wherein electrical ports (24) for supplying current to the shape memory material are provided on the tube (10c).

7. Wire guiding element according to claim 6,
**characterised in that**,
the wire guiding element has a plurality of flattened wires (26) made of a shape memory alloy or a bimetal, on which a respective plurality of heating coils (28) is arranged and which, together with said heating coil (28), are embedded into an elastic, electrically insulating material (30), which, in particular, is thermally conductive.

8. Wire guiding element according to one of the preceding claims,
**characterised in that**,
the wire guiding element in the region of a wire outlet (52) has a sensor device (54) to determine the force exerted by the wire onto the wire guiding element (100c, 100d, 100e, 100f).

9. Wire guiding element according to claim 8,
**characterised in that**,
in the wire guiding element, the sensor device (54) has a piezo-ceramic sensor layer.

10. Wire winding machine (200, 300) having a wire guiding element (100a, 100b, 100b', 100c, 100d, 100e, 100f) according to one of claims 1 to 9.

11. Method for inserting a wire for producing a coil on or in one or several components of an electrical machine, wherein the wire (400) is guided through a wire guiding element (100a, 100b, 100b', 100c, 100d, 100e, 100f) according to one of claims 1 to 9 and the wire guiding element (100a, 100b, 100b', 100c, 100d, 100e, 100f), either under the effect of a force exerted by the wire (400) or through an active actuating of a mechanical or electrical regulating variable, changes, in particular changes repeatedly, the shape of its outer body (10a, 10b, 10b', 10c, 10d, 10e, 10f).

12. Method according to claim 11,
wherein in the method the coil is formed as a distributed winding.

13. Method according to claim 11 or 12, wherein, in the method a wire guiding element (100c, 100d, 100e, 100f) according to claim 9 or 10 is used, and wherein the actuation occurs in response to measurement signals emitted by the sensor device (54).

14. Method for feeding wire from a storage device to a work area, wherein, in the method, the wire is fed through a wire guiding element (100c, 100d, 100e, 100f) according to one of claims 1 to 9, wherein the wire tensile force exerted by the wire onto the wire guiding element (100c, 100d, 100e, 100f) is measured and, depending on this, the form of at least one part of the wire guiding element (100c, 100d, 100e, 100f) is changed in such a way that the wire tensile force is reduced and/or is regulated to a predetermined value, wherein the wire tensile force is measured with regard to its value and its direction.

## Revendications

1. Élément de guidage de fil (100a, 100b, 100b', 100c, 100d, 100e, 100f) pour le guidage d'un fil à enrouler (400) dans une machine d'enroulage de fil (200, 300) ou pour l'introduction d'un fil de brasage dans un appareil de brasage ou d'un additif de soudure sous la forme d'un fil dans une machine à souder, avec un corps extérieur (10a, 10b, 10b', 10c, 10d, 10e, 10f) dans lequel est réalisé un passage (12) pour un fil, le corps extérieur (10a, 10b, 10b', 10c, 10d, 10e, 10f) étant au moins partiellement déformable, de façon à ce que la forme du passage (12) varie également,
**caractérisé en ce que**
le corps extérieur comprend une pluralité d'éléments de réglage (32) dont la forme, plus particulièrement le volume, varie sous l'effet d'une tension électrique, d'un courant électrique ou d'un champ magnétique en tant que grandeur de réglage physique et dans lequel le corps extérieur comprend des moyens (34, 36) pour solliciter les différents éléments de réglage (32) de manière sélective avec la grandeur de réglage tension électrique, courant électrique ou champ magnétique.

2. Élément de guidage de fil selon la revendication 1,
**caractérisé en ce que**
une pluralité d'éléments de réglage (32) sont disposés le long de l'extension longitudinale du corps extérieur (10e).

3. Élément de guidage de fil selon l'une des revendications précédentes,
**caractérisé en ce que**
dans l'élément de guidage de fil, sont disposés au moins deux et de préférence au moins trois éléments de réglage (32) dans différents secteurs (38a, 38b, 38c) d'un anneau autour du passage (12).

4. Élément de guidage de fil selon l'une des revendications précédentes,
**caractérisé en ce que**
dans l'élément de guidage de fil, le corps extérieur (10a) comprend une pluralité de manchons rigides (14a, 14b) qui sont couplés entre eux par paires respectivement par au moins une pièce de liaison flexible (16a), de préférence **en ce que**, dans l'élément de guidage de fil, le corps extérieur (10b, 10b') comprend un tuyau flexible (18) et des premiers manchons métalliques (20) qui reposent sur le tuyau (18) et sont distants les uns des autres.

5. Élément de guidage de fil selon l'une des revendications précédentes,
**caractérisé en ce que**
dans le corps extérieur (10b') de l'élément de guidage de fil, des premiers manchons métalliques annulaires (20) avec un premier diamètre intérieur entourent directement un tuyau flexible (18) et des deuxièmes manchons métalliques annulaires (22) avec un deuxième diamètre intérieur, qui est supérieur au premier diamètre intérieur, reposent chacun sur une portion de deux premiers manchons métalliques (20) adjacents et entourent ainsi le tuyau flexible (18) là où aucun premier manchon métallique (20) n'est présent.

6. Élément de guidage de fil selon l'une des revendications précédentes,
**caractérisé en ce que**
dans l'élément de guidage de fil, le corps extérieur (10c) présente une forme tubulaire et comprend au moins une partie en matériau qui, lors d'un changement de température, provoque une déformation de cette au moins une partie, de préférence **en ce que** l'élément de guidage de fil comprend un tube (10c) en matériau à mémoire de forme, plus particulièrement un alliage à mémoire de forme, des raccords électriques (24) étant disponibles sur le tube (10c) pour l'alimentation électrique du matériau à mémoire de forme.

7. Élément de guidage de fil selon la revendication 6,
**caractérisé en ce que**
l'élément de guidage de fil comprend une pluralité de fils plats (26) en alliage à mémoire de forme ou en bi-métal, sur lequel sont disposées une pluralité de bobines de chauffage (28) et qui sont intégrés, avec ces bobines de chauffage (28), dans un matériau élastique électriquement isolant (30) qui est plus particulièrement thermo-conducteur.

8. Élément de guidage de fil selon l'une des revendications précédentes,
**caractérisé en ce que**
l'élément de guidage de fil comprend, au niveau d'un passage de fil (52), un dispositif de capteur (54) pour la détermination de la force exercée par le fil sur l'élément de guidage de fil (100c, 100d, 100e, 100f).

9. Élément de guidage de fil selon la revendication 8,
**caractérisé en ce que**
dans l'élément de guidage de fil, le dispositif de capteur (54) comprend une couche de capteur piézo-céramique.

10. Machine d'enroulage de fil (200, 300) avec élément de guidage de fil (100a, 100b, 100b', 100c, 100d, 100e, 100f) selon l'une des revendications 1 à 9.

11. Procédé d'insertion d'un fil pour la formation d'une bobine sur ou dans un ou plusieurs composants d'une machine électrique, le fil (400) étant guidé par un élément de guidage de fil (100a, 100b, 100b', 100c, 100d, 100e, 100f) selon l'une des revendications 1 à 9 et la forme du corps extérieur (10a, 10b, 10b', 10c, 10d, 10e, 10f) de l'élément de guidage de fil (100a, 100b, 100b', 100c, 100d, 100e, 100f) changeant, plus particulièrement changeant de manière répétée, soit sous l'effet d'une force exercée par le fil (400) soit du fait d'un contrôle actif d'une grandeur de réglage mécanique ou électrique.

12. Procédé selon la revendication 11, dans lequel la bobine est mise à disposition sous la forme d'un enroulage réparti.

13. Procédé selon la revendication 11 ou 12, dans lequel un élément de guidage de fil (100c, 100d, 100e, 100f) selon la revendication 9 ou 10 est utilisé et dans lequel le contrôle a lieu en réaction aux signaux de mesure émis par le dispositif de capteur (54).

14. Procédé d'introduction d'un fil d'un dispositif de réserve dans une zone de travail, dans lequel le fil est guidé par un élément de guidage de fil (100c, 100d, 100e, 100f) selon l'une des revendications 1 à 9, dans lequel une force de traction exercée sur l'élément de guidage de fil (100c, 100d, 100e, 100f) est mesurée et en fonction de celle-ci la forme d'au moins une partie de l'élément de guidage de fil (100c, 100d, 100e, 100f) est modifiée de façon à ce que la force de traction soit réduite et/ou régulée à une valeur prédéterminée, la force de traction sur le fil étant mesurée en ce qui concerne sa valeur et sa direction.
